# FASCICULE DE BREVET EUROPEEN

(11) **EP 0 744 808 B1**
(45) Date de publication et mention de la délivrance du brevet: **20.09.2000**
(21) Numéro de dépôt: 96410056.4
(22) Date de dépôt: 21.05.1996
(51) Int. Cl.: H02H 9/04, H01L 27/02

(54) **Dispositif d'écrêtage**
Spannungsbegrenzungsvorrichtung
Voltage clipping device

(30) Priorité: 24.05.1995 FR 9506405
(43) Date de publication de la demande: 27.11.1996
(73) Titulaire: STMicroelectronics S.A., 94250 Gentilly (FR)
(72) Inventeur: Pontarollo, Serge, 38800 Pont de Claix (FR)
(74) Mandataire: de Beaumont, Michel

(56) Documents cités:
- EP-A- 0 435 047
- EP-A- 0 575 062
- GB-A- 2 268 007

## Description

La présente invention concerne un dispositif d'écrêtage (clamp) destiné à protéger un circuit intégré contre des surtensions pouvant survenir entre deux bornes de ce circuit intégré.

Des surtensions appliquées entre deux bornes d'un circuit intégré peuvent occasionner la destruction de celui-ci. Ces surtensions proviennent le plus souvent de décharges électrostatiques qui peuvent être appliquées intempestivement aux bornes du circuit intégré dans des circonstances diverses. Ces circonstances peuvent être tout simplement une manipulation du circuit par un opérateur dont les doigts sont portés par des phénomènes de frottement à des potentiels électrostatiques élevés.

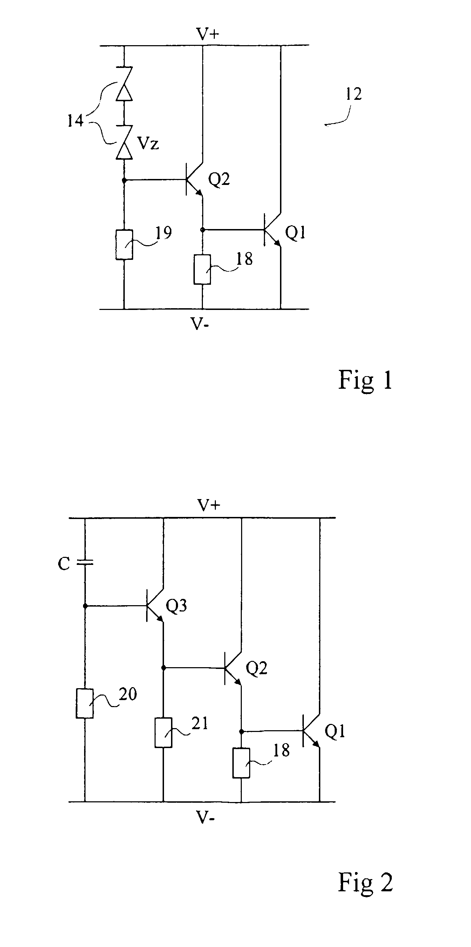

La figure 1 représente un dispositif d'écrêtage 12 classique. Ce dispositif comprend un transistor shunt bipolaire NPN Q1 relié par son collecteur à la borne V+ et son émetteur à la borne V-. Une ou plusieurs diodes zener 14 servent à définir la tension limite entre les bornes V+ et V-, à partir de laquelle le transistor Q1 est mis en conduction. La tension d'anode des diodes zener 14 est appliquée sur la base du transistor Q1 par l'intermédiaire d'un transistor bipolaire NPN suiveur Q2. Les bases des transistors Q1 et Q2 sont reliées à la borne V-par des résistances respectives 18 et 19.

Avec cette configuration, le transistor Q1 est rendu passant lorsque la tension entre les bornes V+ et V- dépasse la valeur Vz + 2Vbe, où Vz est la somme des tensions de zener des diodes 14 et 2Vbe la somme des tensions base-émetteur des transistors Q1 et Q2.

Le transistor Q1 est choisi de manière qu'il présente, à l'état passant, une résistance particulièrement faible. Il a une taille de, par exemple, 300 transistors élémentaires. Le transistor suiveur Q2 sert à fournir un courant de base suffisant au transistor Q1 et comprend pour cela, par exemple, 100 transistors élémentaires.

Un inconvénient de ce dispositif d'écrêtage est qu'il est difficile d'obtenir une tension de zener Vz bien connue. Cette tension de zener doit être supérieure à la tension d'alimentation nominale du circuit mais doit être inférieure à la tension maximale admissible avant rupture du circuit.

Cette plage est relativement restreinte et il arrive souvent que, dès la fabrication, la tension zener obtenue soit trop basse de manière que le dispositif d'écrêtage entre en action dès que l'on alimente normalement le circuit. Il arrive souvent aussi au cours du fonctionnement du circuit, par simple dérive thermique ou vieillissement, que la tension zener décroisse et active le dispositif d'écrêtage alors que le circuit est alimenté normalement.

Un autre inconvénient de ce dispositif d'écrêtage est que le transistor Q1 peut être détruit par une surtension prolongée mais insuffisante pour détériorer le circuit à protéger. Il en résulte que le transistor Q1 est en permanence court-circuité, ce qui rend inutilisable le circuit alors qu'il est en état de marche.

Par ailleurs, tous les dispositifs d'écrêtage connus sont réalisés à l'aide de transistors bipolaires dans des technologies rapides. Une décharge électrostatique présente un front de tension pratiquement immédiat suivi d'une décroissance progressive. C'est essentiellement la valeur de tension initiale qu'il faut atténuer. Pour cela, il est nécessaire que le dispositif d'écrêtage réagisse pratiquement instantanément. Jusqu'à maintenant, on n'est pas parvenu à réaliser un dispositif d'écrêtage efficace dans des technologies CMOS lentes (par exemple HC1PA).

Un objet de la présente invention est de prévoir un dispositif d'écrêtage efficace en technologie CMOS lente, dans lequel on évite le problème d'assurer une tension de déclenchement précise et stable.

Pour atteindre ces objets, la présente invention prévoit un dispositif de protection d'un circuit contre des surtensions, comprenant un transistor MOS de premier type relié à des première et deuxième bornes d'alimentation respectivement par sa source et son drain ; un transistor MOS de deuxième type relié entre la deuxième borne d'alimentation et la grille du transistor de premier type, respectivement par sa source et son drain ; et une capacité dont une première borne est reliée à la première borne d'alimentation et dont la deuxième borne est reliée à la grille du transistor de deuxième type.

Selon un mode de réalisation de la présente invention, le dispositif comprend une diode reliée dans le sens non-passant entre la grille et la source du transistor de deuxième type.

Selon un mode de réalisation de la présente invention, le transistor de premier type est un transistor à canal P, la première borne d'alimentation étant une borne d'alimentation positive.

Ces objets, caractéristiques et avantages ainsi que d'autres de la présente invention seront exposés plus en détail dans la description suivante de modes de réalisation particuliers faite à titre non-limitatif à l'aide des figures jointes parmi lesquelles :
la figure 1, précédemment décrite, représente un dispositif d'écrêtage classique ;
la figure 2 représente un mode de réalisation de dispositif d'écrêtage évitant le problème d'assurer une tension de déclenchement précise et stable ; et
la figure 3 représente un mode de réalisation de dispositif d'écrêtage selon la présente invention.

La figure 2 représente un dispositif d'écrêtage comprenant, comme celui de la figure 1, un transistor Q1 de court-circuit des bornes d'alimentation V+ et V-, commandé par un transistor suiveur Q2.

Une capacité C est reliée entre la borne V+ et la base du transistor suiveur Q2 par l'intermédiaire, éventuellement, d'un transistor NPN suiveur Q3. La capacité C et la base du transistor Q3 sont reliées à la borne V- par une résistance 20. La base du transistor Q1 est reliée à la borne V- par une résistance 18, comme dans la figure 1, et la base du transistor Q2 est reliée à la borne V- par une résistance 21.

Avec cette configuration, le dispositif d'écrêtage est déclenché, c'est-à-dire que le transistor Q1 est rendu passant, lorsque la tension aux bornes de la résistance 20 dépasse 3Vbe (somme des tensions base-émetteur des transistors Q1 à Q3).

La tension aux bornes de la résistance 20 correspond sensiblement à la dérivée de la tension entre les bornes V+ et V-. Ainsi, plus la tension entre les bornes V+ et V- croît rapidement, plus la tension aux bornes de la résistance 20 est élevée.

Lors d'une décharge électrostatique, la capacité C n'a pas le temps de se charger par la résistance 20, c'est-à-dire que la tension de base du transistor Q3 évolue pratiquement comme la tension sur la borne V+. Dans ce cas, le transistor Q1 est rendu passant pratiquement dès que la tension entre les bornes V+ et V- dépasse 3Vbe, ce qui a pour conséquence d'éliminer la surtension.

Par contre, si la tension entre les bornes V+ et V-croît relativement lentement, par exemple à la mise sous tension normale du circuit à protéger, la tension aux bornes de la résistance 20 reste en dessous de 3Vbe. Le dispositif d'écrêtage n'est pas déclenché.

Lorsqu'une surtension permanente est appliquée, le dispositif d'écrêtage n'est pas déclenché non plus, du moins après que la tension entre les bornes V+ et V- a atteint une valeur stable. Ceci permet de ne pas détruire le transistor Q1 lors de surtensions permanentes ne détériorant pas le circuit à protéger.

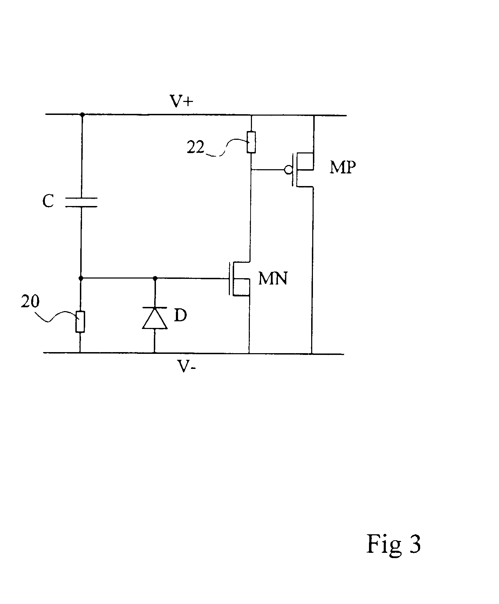

La pente de croissance de la tension entre les bornes V+ et V- qui déclenche le dispositif d'écrêtage est déterminée par les valeurs de la capacité C, de la résistance 20, de la tension (3Vbe dans la figure 3) qui provoque la mise en conduction du transistor Q1, et du gain de l'ensemble des transistors Q1 à Q3. Cette pente est choisie, par exemple, supérieure à celle de la mise sous tension normale du circuit à protéger.

Pour réaliser un dispositif d'écrêtage en technologie CMOS lente, telle que la technologie HC1PA, on pourrait envisager de remplacer les transistors bipolaires de la structure de la figure 2 par des transistors MOS. Il s'avère que le dispositif ainsi obtenu n'est pas efficace, c'est-à-dire que le circuit qu'il est sensé protéger est détruit dans la plupart des cas, sous des conditions de test normalisées (capacité de 100 picofarads chargée de 2 à 4 kilovolts que l'on décharge dans le circuit à travers une résistance de 1500 ohms). Cette inefficacité est due à un manque de rapidité du dispositif. En effet, l'efficacité du transistor MOS shunt qui remplace le transistor Q1 dépend directement de sa tension grille-source. Or cette tension grille-source est inférieure au tiers de la tension aux bornes de la résistance 20, qui suit l'évolution d'une surtension. La surtension a le temps de détruire le circuit à protéger avant que cette tension grille-source n'atteigne une valeur suffisante pour que le transistor shunt absorbe la surtension.

Il s'avère, dans les technologies CMOS, que l'on peut réaliser des transistors bipolaires NPN de structure verticale, la seule contrainte étant que les collecteurs de ces transistors NPN correspondent au substrat, c'est-à-dire à la borne d'alimentation positive V₊. On peut donc réaliser le circuit de la figure 2, à transistors bipolaires, dans une technologie CMOS pure. Néanmoins, des essais ont démontré que le dispositif d'écrêtage ainsi réalisé est toujours trop lent pour être efficace à cause de la lenteur des transistors bipolaires verticaux.

La figure 3 représente un dispositif d'écrêtage qui est efficace même s'il est réalisé dans une technologie CMOS lente. Ce dispositif comprend un transistor MOS à canal P MP relié entre les bornes d'alimentation V+ et V- respectivement par sa source et son drain. Un transistor MOS à canal N MN est relié entre la grille du transistor MP et la borne V-, respectivement par son drain et sa source. La grille du transistor MN est reliée à la borne V+ par une capacité C. Des résistances 20 et 22 sont reliées entre grille et source des transistors MN et MP, respectivement, et servent à décharger les capacités grille-source de ces transistors, lorsque les grilles ne sont pas alimentées.

Lors d'une surtension, la capacité C n'a pas le temps de se charger par la résistance 20, c'est-à-dire que la tension de grille du transistor MN évolue comme la tension sur la borne V+. Dès que cette tension-grille atteint la tension seuil du transistor MN, ce dernier se met à conduire et rapproche la tension de grille du transistor MP de la tension V-. Ainsi, le transistor MP se met également à conduire et court-circuite les bornes V+ et V- pour atténuer la surtension.

Une raison pour laquelle le circuit de la figure 3 est particulièrement rapide est que la tension grille-source du transistor MP atteint vite une valeur importante (égale à la tension d'alimentation du circuit) qui le rend suffisamment conducteur pour atténuer la surtension. En effet, dès que la tension grille du transistor MN dépasse la tension seuil d'une certaine valeur, nettement inférieure à la valeur de la surtension, le transistor MN entre en régime linéaire, c'est-à-dire qu'il se comporte comme une résistance de faible valeur, et ramène la tension de grille du transistor MP pratiquement à la tension V-. Le transistor MN entre rapidement en régime linéaire car la capacité grille-source de ce transistor constitue, avec la capacité C, un pont diviseur capacitif qui entraîne que la tension de grille du transistor MN varie proportionnellement à la surtension, le coefficient de proportionnalité étant d'autant plus élevé que la capacité C est élevée.

Pour obtenir un bon compromis entre la taille de la capacité C et la rapidité de commande du transistor MN, ce transistor MN est de préférence de taille relativement faible. Il en résulte que ce transistor MN n'est pas capable d'absorber la surtension qui doit être absorbée par le transistor MP, de taille nettement plus grande que celle du transistor MN.

A titre d'exemple, dans un dispositif capable d'absorber des surtensions de 4 kV, le transistor MN a un rapport W/L de 1500/5, le transistor MP a un rapport W/L de 10 000/5, et la capacité C a une valeur de 8 picofarads. Les résistances 20 et 22 ont, par exemple, une valeur de 6 kilo-Ohms. Si l'on souhaite obtenir une tenue en tension de 2 kV, le rapport W/L du transistor MP pourra être réduit à 5000/5.

Un dispositif comme celui de la figure 2, est activé dès que la tension entre les bornes V+ et V- évolue rapidement. Comme on l'a précédemment indiqué, dans le dispositif de la figure 2, on choisit les composants pour que le dispositif ne soit pas déclenché lors d'une mise sous tension normale. En effet, la source d'alimentation du circuit présente généralement une impédance particulièrement faible qui pourrait provoquer la destruction du dispositif d'écrêtage si celui-ci venait à être déclenché.

Malgré un choix judicieux des composants, il est toujours possible de rencontrer le cas où une mise sous tension normale déclenche le dispositif et provoque sa destruction s'il est réalisé avec des transistors bipolaires. En effet, un transistor bipolaire saturé présente une très faible résistance quel que soit le courant qui le traverse, cette résistance devenant d'autant plus faible que le transistor s'échauffe, ce qui tend rapidement à détruire le transistor bipolaire.

Par contre, le fait qu'un dispositif d'écrêtage selon l'invention, réalisé à partir de transistors MOS, se déclenche lors d'une mise sous tension normale, n'est pas gênant. En effet, le transistor MOS MP tend à se comporter canine une source de courant de valeur déterminée par sa tension grille-source. Ainsi, le courant qui le traverse ne dépassera jamais cette valeur et, tant qu'il est inférieur, le transistor MP se comporte comme une résistance de faible valeur. En outre, un transistor MOS présente un coefficient thermique positif qui tend à diminuer le courant qui traverse le transistor lorsque sa température augmente. Ces caractéristiques combinées entraînent que le dispositif d'écrêtage selon l'invention est particulièrement robuste.

Bien entendu, les types des transistors MN et MP peuvent être inversés, en inversant les polarités des bornes d'alimentation V+ et V-. Ceci a pour avantage de diminuer la surface occupée par le circuit, puisque le transistor qui doit supporter la surtension est alors un transistor à canal N qui est sensiblement trois fois plus petit qu'un transistor à canal P de mêmes caractéristiques. Toutefois, un transistor MOS à canal N a l'inconvénient qu'il présente un transistor bipolaire parasite entre son drain et sa source. Ce transistor bipolaire parasite, traversé par le courant du transistor MOS, diminue la robustesse du circuit à cause de son coefficient thermique négatif.

Comme cela est représenté, une diode D est connectée, dans le sens non-passant, entre la grille et la source du transistor MN. Cette diode D évite que la tension de grille du transistor MN devienne trop négative par rapport à la tension V-. En effet, la tension de grille du transistor MN est égale à la tension sur la borne V+ moins la tension aux bornes de la capacité C. Ainsi, si la tension V+ atteint rapidement sa valeur initiale, après une surtension, la capacité C n'a pas le temps de se décharger dans la résistance 20, ce qui provoque une surtension négative entre la grille et la source du transistor MN pouvant entraîner sa destruction.

## Revendications

1. Dispositif de protection d'un circuit contre des surtensions, caractérisé en ce qu'il comprend :
- un transistor MOS de premier type (MP) relié à des première et deuxième bornes d'alimentation (V+, V-) respectivement par sa source et son drain ;
- un transistor MOS de deuxième type (MN) relié entre la deuxième borne d'alimentation (V-) et la grille du transistor de premier type, respectivement par sa source et son drain ; et
- une capacité (C) dont une première borne est reliée à la première borne d'alimentation (V+) et dont la deuxième borne est reliée à la grille du transistor de deuxième type.

2. Dispositif de protection selon la revendication 1, caractérisé en ce que deux sources de courant (20, 22) relient la grille et la source des transistors de premier et deuxième types respectivement.

3. Dispositif de protection selon la revendication 1, caractérisé en ce qu'il comprend une diode (D) reliée dans le sens non-passant entre la grille et la source du transistor de deuxième type.

4. Dispositif de protection selon l'une quelconque des revendications précédentes, caractérisé en ce que le transistor de premier type est un transistor à canal P, la première borne d'alimentation (V+) étant une borne d'alimentation positive.

## Patentansprüche

1. Schutzvorrichtung für eine Schaltung gegen Überspannungen, dadurch gekennzeichnet, daß sie aufweist:
- einen MOS-Transistor vom ersten Leitungstyp (MP), der mit seiner Source und seiner Drain an einen ersten bzw. zweiten Versorgungsanschluß (V+, V-) angeschlossen ist;
- einen MOS-Transistor vom zweiten Leitungstyp (MN), der mit seiner Source und seiner Drain an den zweiten Versorgungsanschluß (V-) bzw. das Gate des Transistors vom ersten Leitungstyp angeschlossen ist; und
- einen Kondensator (C), dessen einer Anschluß an den ersten Versorgungsanschluß (V+) und dessen zweiter Anschluß an das Gate des Transistors vom zweiten Leitungstyp angeschlossen ist.

2. Schutzvorrichtung nach Anspruch 1, dadurch gekennzeichnet, daß zwei Stromquellen (20, 22) an das Gate bzw. die Source des Transistors vom ersten bzw. zweiten Leitungstyp angeschlossen sind.

3. Schutzvorrichtung nach Anspruch 1, dadurch gekennzeichnet, daß sie eine Diode (D) aufweist, die in Sperrichtung zwischen das Gate und die Source des Transistors vom zweiten Leitungstyp geschaltet ist.

4. Schutzvorrichtung nach einem der vorhergehenden Ansprüche, dadurch gekennzeichnet, daß der Transistor vom ersten Leitungstyp ein Transistor mit einem P-Kanal ist, wobei der erste Versorgungsanschluß (V⁺) ein positiver Versorgungsanschluß ist.

## Claims

1. A device for protecting a circuit against voltage surges, characterized in that it includes:
- a MOS transistor of a first type (MP) connected to first and second supply terminals (V+, V-) by its source and its drain, respectively;
- a MOS transistor of a second type (MN) connected between the second supply terminal (V-) and the gate of the transistor of the first type by its source and its drain, respectively; and
- a capacitor (C) having a first terminal connected to the first supply terminal (V+) and a second terminal connected to the gate of the transistor of the second type.

2. A protection device according to claim 1, characterized in that a resistor (20, 22) interconnects the gate and the source of each of the transistors of the first and second type.

3. A protection device according to claim 1, characterized in that it includes a reverse connected diode (D) between the gate and the source of the transistor of the second type.

4. A protection device according to any of the preceding claims, characterized in that the transistor of the first type is a P-channel transistor, the first supply terminal (V+) being a positive supply terminal.
